# EUROPÄISCHE PATENTANMELDUNG

(11) **EP 1 049 260 A2**
(43) Veröffentlichungstag der Anmeldung: **02.11.2000**
(21) Anmeldenummer: 00100826.7
(22) Anmeldetag: 17.01.2000
(51) Int. Cl.: H04B 1/03, H04B 1/08

(54) **HF-Baugruppe mit Tuner und HF-Sendeempfänger**

(30) Priorität: 26.04.1999 DE 19918888; 11.06.1999 DE 19926763
(71) Anmelder: Microtune GmbH, 85055 Ingolstadtng (DE)
(72) Erfinder: Manhart, Rudolf, 85051 Ingolstadt (DE)
(74) Vertreter: Bohnenberger, Johannes, Dr.

(57) **Zusammenfassung**

Es wird eine Hochfrequenz-Baugruppe für Rundfunk-, Fernseh- und dergleichen Empfangsgeräte angegeben, die einen Tuner (10), eine Sende-Empfangs-Einheit (12) und ein Abschirmgehäuse (14) umfaßt. Der Tuner (10) ist zum Empfangen von Rundfunk-, Fernseh- und/oder dergleichen Signalen vorgesehen. Die Sende-Empfangs-Einheit (12) ist zum Senden und Empfangen von Informationssignalen vorgesehen. Sowohl der Tuner (10) als auch die Sende-Empfangs-Einheit (12) sind in dem Abschirmgehäuse (14) integriert.

## Beschreibung

Die Erfindung betrifft eine Hochfrequenz-Baugruppe für Rundfunk-, Fernseh- und dergleichen Empfangsgeräte. Beispielsweise kann die Hochfrequenz-Baugruppe auch für Satelliten-Receiver, Videorecorder, Set-Top-Boxen oder Personal Computer vorgesehen sein.

Üblicherweise umfaßt eine Hochfrequenz-Baugruppe einen Tuner, der über eine Antenne und/oder ein HF-Kabel zugeführte HF-Signale weiterverarbeitet. Diese modulierten HF-Signale enthalten beispielsweise Ton-, Bild- und/oder Dateninformationen. Ausgangsseitig stellt ein Tuner meist ein sogenanntes ZF-Signal zur weiteren Verarbeitung bereit.

Weiterhin ist es erwünscht, daß Empfangsgeräte, die einen Tuner enthalten, zur bi-direktionalen drahtlosen Kommunikation geeignet sind. Dies läßt sich mit einer Sende-Empfangs-Einheit realisieren, die im HF-Bereich arbeitet. Mit einer derartigen Sende-Empfangs-Einheit ist es beispielsweise möglich, einerseits Signale von einer Fernbedienung zu empfangen und andererseits Tonsignale von einem Fernsehgerät drahtlos zu einem Lautsprecher zu übertragen. Wird dabei ein standardisiertes Übertragungsverfahren benutzt, ist eine Kommunikation zwischen allen denkbaren Geräten, die eine derartige Sende-Empfangs-Einheit oder ein dazu kompatibles Gerät aufweisen, denkbar.

Werden jedoch ein Tuner und eine Sende-Empfangs-Einheit in einem Fernsehgerät oder dergleichen verwendet, ist der schaltungstechnische Aufwand relativ groß. Sowohl der Tuner als auch die Sende-Empfangs-Einheit arbeiten im Hochfrequenzbereich. Für beide Schaltungen ist eine sorgfältige Abschirmung erforderlich, um andere Baugruppen nicht zu stören. Abschirmeinrichtungen sind im Vergleich mit elektronischen Bauelementen relativ kostenintensiv.

Es ist Aufgabe der Erfindung, eine Hochfrequenz-Baugruppe bereitzustellen, die einerseits zum Empfang von Rundfunk- und Fernsehsignalen und andererseits zur bi-direktionalen drahtlosen Kommunikation mit anderen Geräten geeignet ist, wobei der schaltungstechnische und mechanische Aufwand gering bleibt.

Diese Aufgabe wird durch den Gegenstand gemäß den Merkmalen des Patentanspruches 1 gelöst.

Erfindungsgemäß ist eine Hochfrequenz-Baugruppe für Rundfunk-, Fernseh- und dergleichen Empfangsgeräte vorgesehen, die folgendes aufweist:
- einen Tuner zum Empfangen von Rundfunk-, Fernseh- und/oder dergleichen Signalen;
- eine Sende-Empfangs-Einheit zum Senden und Empfangen von Informationssignalen; und
- ein Abschirmgehäuse, in dem der Tuner und die Sende-Empfangs-Einheit integriert sind.

Bei der erfindungsgemäßen Hochfrequenz-Baugruppe ist ein einziges Abschirmgehäuse vorgesehen, um die beiden Hochfrequenzschaltungen ausreichend abzuschirmen. Da als Abschirmeinrichtungen üblicherweise Metallgehäuse verwendet werden, kann bei der erfindungsgemäßen Vorrichtung ein Metallgehäuse eingespart werden. Dies ist ein wesentlicher Beitrag zur Kostenreduzierung.

Weiterhin kann vorgesehen sein, daß die Hochfrequenz-Baugruppe als Schaltungsmodul ausgebildet ist, das lösbar in einem Empfangsgerät montierbar ist. Dadurch läßt sich auf einfache Weise die Hochfrequenz-Baugruppe bei Bedarf auswechseln.

Insbesondere ist vorgesehen, daß die Hochfrequenz-Baugruppe als Steckkarte ausgebildet ist. Dies ermöglicht einen besonders schnellen Austausch der Hochfrequenz-Baugruppe.

Weiterhin kann vorgesehen sein, daß die Steckkarte eine Steckerleiste aufweist. Dabei ist vorzugsweise die Steckerleiste nach einem vorbestimmten Standard ausgebildet. Dadurch ist die Hochfrequenz-Baugruppe zu zahlreichen Geräten kompatibel.

Weiterhin kann vorgesehen sein, daß die Steckerleiste eine Vielzahl Anschlüsse aufweist, die dem Tuner und/oder der Sende-Empfangs-Einheit zugeordnet sind. Damit läßt sich sowohl für den Tuner als auch für die Sende-Empfangs-Einheit ein standardisierter Anschluß bereitstellen. Auch dies trägt dazu bei, daß die Hochfrequenz-Baugruppe in großen Stückzahlen herstellbar und damit kostengünstig ist.

Weiterhin kann vorgesehen sein, daß die Hochfrequenz-Baugruppe eine Abschirmeinrichtung aufweist, um den Tuner und die Sende-Empfangs-Einheit voneinander abzuschirmen. Auf diese Weise wird verhindert, daß sich der Tuner und die Sende-Empfangs-Einheit gegenseitig stören.

Für die Abschirmeinrichtung kann vorgesehen sein, daß sie als Gehäuseteil oder Gehäuse ausgebildet ist, in dem entweder der Tuner oder die Sende-Empfangs-Einheit integriert ist. Vorzugsweise ist die Abschirmeinrichtung so ausgebildet, daß sie das Abschirmgehäuse in zwei Bereiche unterteilt, von denen der eine für den Tuner und der andere für die Sende-Empfangs-Einheit vorgesehen ist. Damit lassen sich der Tuner und die Sende-Empfangs-Einheit besonders kostengünstig sowohl nach außen als auch voneinander abschirmen.

Weiterhin kann vorgesehen sein, daß die Hochfrequenz-Baugruppe eine Entkopplungseinrichtung aufweist, die zwischen dem Tuner und der Sende-Empfangs-Einheit geschaltet ist. Dies trägt zu einer Entstörung zwischen dem Tuner und der Sende-Empfangs-Einheit und damit zur Funktionssicherheit der gesamten Hochfrequenz-Baugruppe bei.

Vorzugsweise ist vorgesehen, daß die Sende-Empfangs-Einheit für die ISM-Frequenzbereiche vorgesehen ist. Das Senden und Empfangen von ISM-Frequenzen ist gebührenfrei und zur Übertragung analoger und digitaler Signale geeignet.

Weiterhin kann vorgesehen sein, daß die Sende-Empfangs-Einheit für die Übertragung von Signalen mit standardisierten Frequenzen, Modulationsarten, Sendeleistungen, Bandbreiten, Empfangsparameter und/oder Softwareprotokollen vorgesehen ist. Dadurch kann die erfindungsgemäße Hochfrequenz-Baugruppe mit anderen Geräten kommunizieren, die den gleichen Standard verwenden. Diese Geräte können beispielsweise Telefone, Personal-Computer, Fernbedienungen oder jedes andere beliebige Haushaltsgerät sein.

Weitere Merkmale der Erfindung sind Gegenstand der Unteransprüche.

Nachstehend wird eine Ausführungsform einer erfindungsgemäßen Hochfrequenz-Baugruppe anhand der beigefügten Zeichnung näher erläutert. Es zeigen:
- Figur 1:: eine schematische Ansicht einer erfindungsgemäßen Hochfrequenz-Baugruppe; und
- Figur 2:: eine schematische Ansicht einer alternativen Ausführungsform der erfindungsgemäßen Hochfrequenz-Baugruppe.

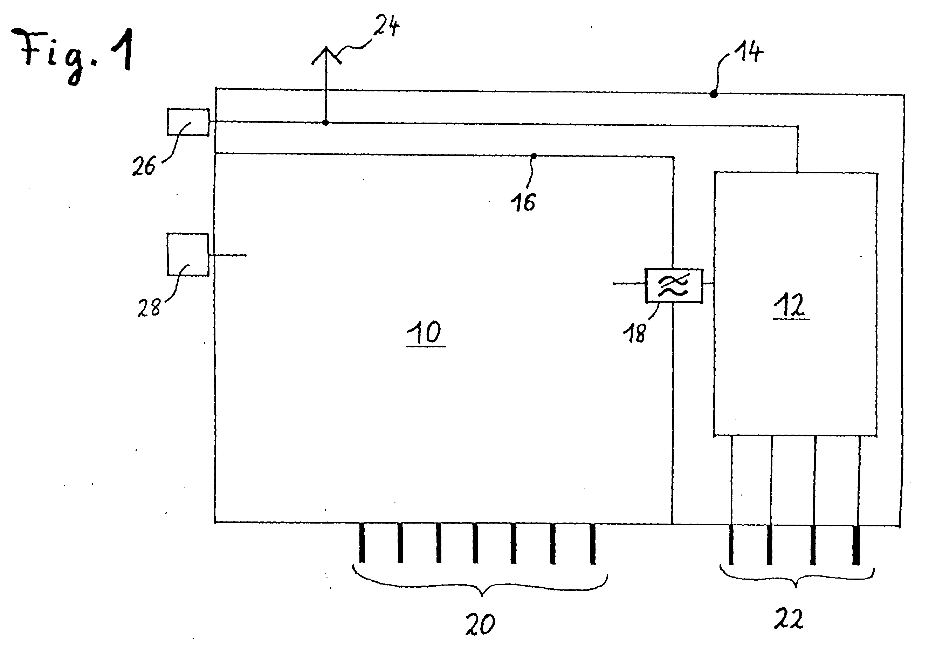

In Figur 1 ist eine Hochfrequenz-Baugruppe gezeigt, die auf einer einzigen Platine ausgebildet ist. Die Hochfrequenz-Baugruppe umfaßt einen Tuner 10 und eine Sende-Empfangs-Einheit 12. Die Hochfrequenz-Baugruppe umfaßt weiterhin ein Abschirmgehäuse 14, das sowohl den Tuner 10 als auch die Sende-Empfangs-Einheit 12 umschließt. Das Abschirmgehäuse 14 ist vorzugsweise als Metallgehäuse ausgebildet. Weiterhin weist die Hochfrequenz-Baugruppe eine Abschirmeinrichtung 16 auf, die den Tuner 10 teilweise umschließt und das Abschirmgehäuse 14 in zwei voneinander abgeschirmte Bereiche unterteilt. Die beiden Bereiche sind jeweils dem Tuner 10 bzw. der Sende-Empfangs-Einheit 12 zugeordnet. Zwischen dem Tuner 10 und der Sende-Empfangs-Einheit 12 ist eine Entkopplungseinrichtung 18 geschaltet. Die Entkopplungseinrichtung 18 ist vorzugsweise als Tiefpaß-Schaltung ausgebildet. Der sende-Empfangs-Einheit 12 ist eine Antenne 24 zugeordnet. Die Antenne 24 ist ebenfalls in der Hochfrequenz-Baugruppe integriert. Weiterhin ist der Sende-Empfangs-Einheit 12 ein erster Antennenanschluß 26 zugeordnet. Dem Tuner 10 ist ein zweiter Antennenanschluß 28 zugeordnet. Bei Benutzung unterschiedlicher Frequenzen für die Sende-Empfangs-Einheit 12 einerseits sowie den Tuner 10 andererseits kann ein gemeinsamer Antennanschluß verwendet werden. In diesem Fall müssen die Signale für den Tuner 10 und die der Sende-Empfangs-Einheit 12 entkoppelt werden. Die Hochfrequenz-Baugruppe weist weiterhin eine Steckerleiste auf, die einen ersten Anschlußbereich 20 und einen zweiten Anschlußbereich 22 umfaßt. Der erste Anschlußbereich 20 umfaßt eine Vielzahl Anschlüsse, die dem Tuner 10 zugeordnet sind. Der zweite Anschlußbereich 22 umfaßt eine Vielzahl Anschlüsse, die der Sende-Empfangs-Einheit 12 zugeordnet sind. Alle Anschlüsse befinden sich auf einer Seite der Platine, so daß die Hochfrequenz-Baugruppe als Steckkarte ausgebildet ist.

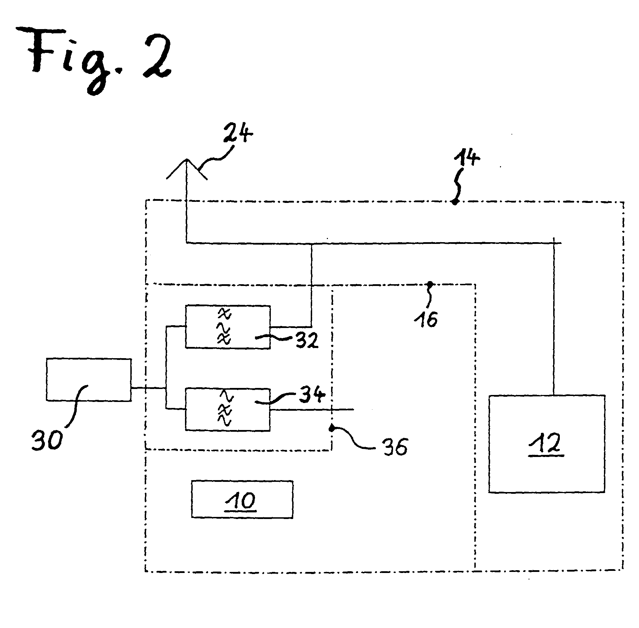

Figur 2 zeigt eine alternative Ausführungsform der erfindungsgemäßen Hochfrequenz-Baugruppe. Diese Ausführungsform unterscheidet sich von derjenigen gemäß Figur 1 lediglich dadurch, daß sie anstelle des ersten 26 und zweiten 28 Antennenanschlusses einen einzigen gemeinsamen Antennenanschluß 30 und eine dem gemeinsamen Antennenanschluß 30 zugeordnete Entkopplungsschaltung aufweist. Die Entkopplungsschaltung umfaßt einen Bandpaß 32 und eine Bandsperre 34 und ist durch eine weitere Abschirmeinrichtung 36 von den übrigen Bauelementen abgeschirmt. Der Bandpaß 32 und die Bandsperre 34 sind eingangsseitig mit dem gemeinsamen Antennenanschluß 30 gekoppelt. Der Bandpaß 32 ist ausgangsseitig mit der Antenne 24 und der Sende-Empfangs-Einheit 12 gekoppelt. Die Bandsperre 34 ist ausgangsseitig mit dem Tuner 10 gekoppelt. Bei dieser alternativen Ausführungsform reicht ein einziger Antennenanschluß 30 aus, sofern für den Tuner 10 und die Sende-Empfangs-Einheit 12 unterschiedliche Frequenzbereiche verwendet werden.

Der Tuner 10 ist zum Empfang von Rundfunk- und/oder Fernsehsignalen vorgesehen. Über den zweiten Antennenanschluß 28 ist der Tuner 10 beispielsweise an eine terrestrische Antenne, eine Satellitenantenne oder ein Fernsehkabelnetz anschließbar. Der Tuner 10 verarbeitet ein empfangenes HF-Signal, das im allgemeinen sowohl frequenz- als auch amplitudenmoduliert ist. Ausgangsseitig stellt der Tuner 10 ein ZF-Signal bereit, das von einem ZF-Verstärker oder von einem Demodulator weiterverarbeitet wird. Das ZF-Signal wird über einen oder mehrere der Anschlüsse 20 ausgegeben.

Die Sende-Empfangs-Einheit 12 ist zur Übertragung von Informationssignalen vorgesehen. Die Informationssignale werden vorzugsweise drahtlos übertragen, und zwar entweder über die in der Hochfrequenz-Baugruppe integrierte Antenne 24 oder über eine externe Antenne, die mit dem ersten Antennenanschluß 26 gekoppelt ist. Alternativ dazu wäre auch eine Übertragung der Informationssignale über ein HF-Kabelnetz, beispielsweise ein hausinternes HF-Kabelnetz, das über den ersten Antennenanschluß 26 mit der Hochfrequenz-Baugruppe gekoppelt ist, denkbar. Die Anschlüsse 22 sind zur Stromversorgung und zur Steuerung der Sende-Empfangs-Einheit 12 vorgesehen. Außerdem sind die Anschlüsse 22 zur Kopplung der Sende-Empfangs-Einheit 12 mit anderen Baugruppen des Gerätes vorgesehen. Weiterhin kann zumindest ein Teil der Anschlüsse 20 und/oder 22 als standardisierter Bus ausgebildet sein. Der standardisierte Bus kann sowohl zur Steuerung des Tuners 10 als auch der Sende-Empfangs-Einheit 12 verwendet werden. Ein gemeinsamer Bus für Tuner 10 und Sende-Empfangs-Einheit 12 ermöglicht einen geringen schaltungstechnischen Aufwand.

Weiterhin kann eine gemeinsame Stromversorgung für Tuner 10 und Sende-Empfangs-Einheit 12 über die Anschlüsse 20 und/oder 22 vorgesehen sein, was ebenfalls einen geringen schaltungstechnischen Aufwand ermöglicht.

Das Abschirmgehäuse 14 schirmt sowohl den Tuner 10 als auch die Sende-Empfangs-Einheit 12 elektromagnetisch nach außen ab. Durch die Abschirmeinrichtung 16 werden der Tuner 10 und die Sende-Empfangs-Einheit 12 elektromagnetisch voneinander abgeschirmt. Die Entkopplungseinrichtung 18 unterbindet ebenfalls eine gegenseitige Störung von Tuner 10 und Sende-Empfangs-Einheit 12. Die Entkopplungseinrichtung 18 unterdrückt unerwünschte Signale, insbesondere Hochfrequenz-Signale.

Die Hochfrequenz-Baugruppe gemäß der Erfindung findet insbesondere Verwendung in Rundfunkgeräten, Fernsehgeräten, Set-Top-Boxen, Satellitenreceivern, Videorecordern und TV-Karten für Personal Computer. Die Sende-Empfangs-Einheit 12 kann dabei auch als Ersatz für die herkömmliche Fernbedienung verwendet werden. Da standardisierte Übertragungsverfahren benutzt werden, ist auch eine Kommunikation zwischen der Hochfrequenz-Baugruppe und beispielsweise einer Telefonanlage möglich. Dies ermöglicht unter anderem eine Fernprogrammierung eines Videorecorders oder eines Fernsehgerätes über das Telefon. Aufgrund der bi-direktionalen Übertragung der Informationssignale mittels der Sende-Empfangs-Einheit 12 ist es zum Beispiel möglich, bei Abwesenheit der Eltern den Fernsehkonsum der Kinder zu kontrollieren. Weiterhin ist es möglich, von einem Fernsehgerät oder von einem Videorecorder aus drahtlos Tonsignale zu externen Lautsprechern zu übertragen. Die übliche Kabelverbindung zwischen dem Empfangsgerät und dem Lautsprecher entfällt dadurch. Weiterhin ist es möglich, im Prinzip jedes beliebige Haushaltsgerät, das eine Sende-Empfangs-Einheit 12 oder eine dazu kompatible Einheit aufweist, durch einen Personal Computer mit einer erfindungsgemäßen Hochfrequenz-Baugruppe anzusteuern.

### Bezugszeichenliste

- 10: Tuner
- 12: Sende-Empfangs-Einheit
- 14: Abschirmgehäuse
- 16: Abschirmeinrichtung
- 18: Entkopplungseinrichtung
- 20: erster Anschlußbereich
- 22: zweiter Anschlußbereich
- 24: Antenne
- 26: erster Antennanschluß
- 28: zweiter Antennenanschluß
- 30: gemeinsamer Antennanschluß
- 32: Bandpaß
- 34: Bandsperre
- 36: Abschirmeinrichtung

## Patentansprüche

1. Hochfrequenz-Baugruppe für Rundfunk-, Fernseh- und dergleichen Empfangsgeräte, die folgendes aufweist:
- einen Tuner (10) zum Empfangen von Rundfunk-, Fernseh- und/oder dergleichen Signalen;
- eine Sende-Empfangs-Einheit (12) zum Senden und Empfangen von Informationssignalen; und
- ein Abschirmgehäuse (14), in dem der Tuner (10) und die Sende-Empfangs-Einheit (12) integriert sind.

2. Hochfrequenz-Baugruppe nach Anspruch 1,
**dadurch gekennzeichnet,**
daß die Hochfrequenz-Baugruppe als Schaltungsmodul ausgebildet ist, das lösbar in einem Empfangsgerät montierbar ist.

3. Hochfrequenz-Baugruppe nach Anspruch 2,
**dadurch gekennzeichnet,**
daß die Hochfrequenz-Baugruppe als Steckkarte ausgebildet ist.

4. Hochfrequenz-Baugruppe nach Anspruch 3,
**dadurch gekennzeichnet,**
daß die Steckkarte eine Steckerleiste (20, 22) aufweist.

5. Hochfrequenz-Baugruppe nach Anspruch 4,
**dadurch gekennzeichnet,**
daß die Steckerleiste (20, 22) nach einem vorbestimmten Standard ausgebildet ist.

6. Hochfrequenz-Baugruppe nach Anspruch 4 oder 5,
**dadurch gekennzeichnet,**
daß die Steckerleiste (20, 22) eine Vielzahl Anschlüsse aufweist, die dem Tuner (10) und/oder der Sende-Empfangs-Einheit (12) zugeordnet sind.

7. Hochfrequenz-Baugruppe nach einem der Ansprüche 3-6,
**dadurch gekennzeichnet,**
daß die Steckkarte als PC-Steckkarte ausgebildet ist.

8. Hochfrequenz-Baugruppe nach einem der Ansprüche 1-7,
**dadurch gekennzeichnet,**
daß die Hochfrequenz-Baugruppe eine Abschirmeinrichtung (16) aufweist, die den Tuner (10) und die Sende-Empfangs-Einheit (12) elektromagnetisch voneinander abzuschirmt.

9. Hochfrequenz-Baugruppe nach Anspruch 8,
**dadurch gekennzeichnet,**
daß die Abschirmeinrichtung (16) als Gehäuseteil oder Gehäuse ausgebildet ist, das das Abschirmgehäuse (14) in wenigstens zwei Bereiche unterteilt.

10. Hochfrequenz-Baugruppe nach Anspruch 9,
**dadurch gekennzeichnet,**
daß die beiden Bereiche des Abschirmgehäuses (14) jeweils dem Tuner (10) und der Sende-Empfangs-Einheit (12) zugeordnet sind.

11. Hochfrequenz-Baugruppe nach einem der Ansprüche 1-10,
**dadurch gekennzeichnet,**
daß die Hochfrequenz-Baugruppe eine Entkopplungseinrichtung (18) aufweist, die zwischen dem Tuner (10) und der Sende-Empfangs-Einheit (12) geschaltet ist.

12. Hochfrequenz-Baugruppe nach einem der Ansprüche 1-11,
**dadurch gekennzeichnet,**
daß die Sende-Empfangs-Einheit (12) für die ISM-Frequenzbereiche vorgesehen ist.

13. Hochfrequenz-Baugruppe nach einem der Ansprüche 1-12,
**gekennzeichnet durch**
einen Bus-Anschluß, mit dem der Tuner (10) und/oder die Sende-Empfangs-Einheit (12) verbunden sind/ist.

14. Hochfrequenz-Baugruppe nach einem der Ansprüche 1-13,
**gekennzeichnet durch**
einen Stromversorgungsanschluß, an den der Tuner (10) und/oder die Sende-Empfangs-Einheit (12) gekoppelt sind/ist.
